Europäisches Patentamt

European Patent Office

Office européen des brevets

(11) Publication number: **0 063 028**
**B1**

(12) **EUROPEAN PATENT SPECIFICATION**

(45) Date of publication of patent specification: **06.08.86**

(21) Application number: **82301835.3**

(22) Date of filing: **07.04.82**

(51) Int. Cl.⁴: **H 01 L 27/02**

(54) Semiconductor integrated circuit.

(30) Priority: **08.04.81 JP 51783/81**

(43) Date of publication of application:
**20.10.82 Bulletin 82/42**

(45) Publication of the grant of the patent:
**06.08.86 Bulletin 86/32**

(84) Designated Contracting States:
**DE FR GB IT**

(56) References cited:

PATENTS ABSTRACTS OF JAPAN, vol. 2, no.
121, October 12, 1978, page 7074 E 78
SIEMENS FORSCH. & ENTWICKL. BERICHTE,
vol. 9, no. 1, 1980, pages 41-46, Berlin, DE, W.
UMKEHRER et al.: "Verlustarme
grossintegrierte Matrixbaustein in I2L-Technik"

(73) Proprietor: **Hitachi, Ltd.**
**5-1, Marunouchi 1-chome**
**Chiyoda-ku Tokyo 100 (JP)**

(72) Inventor: **Kaneko, Kenji**
**Hitachi-Owada Apartment House E204**
**47-2, Akatsukicho-1-chome Hachioji-shi (JP)**
Inventor: **Nagata, Minoru**
**1558 Josuihoncho**
**Kodaira-shi (JP)**
Inventor: **Furihata, Makoto**
**1071-75 Nagyoku Tamamuracho**
**Sawa-gun Gunma-ken (JP)**
Inventor: **Ogura, Setsuo**
**1421 Kaminakaicho**
**Takasaki-shi (JP)**
Inventor: **Okabe, Takahiro**
**2196-36 Hirai Hinodecho**
**Nishitama-gun Tokyo (JP)**
Inventor: **Sato, Mitsuya**
**9-15 Fujimoto-1-chome**
**Kokubunji-shi (JP)**

(74) Representative: **Paget, Hugh Charles Edward**
**et al**
**MEWBURN ELLIS & CO. 2/3 Cursitor Street**
**London EC4A 1BQ (GB)**

Courier Press, Leamington Spa, England.

## Description

The present invention relates to a semiconductor integrated circuit, and in particular, a semiconductor integrated circuit which includes low voltage circuits, such as integrated injection logic circuits (hereinafter referred to as $I^2L$ circuits ECL (Emitter Couple Logic), TTL (Transistor-Transistor Logic), or amplifier circuits adapted for low voltage operation.

In the following description, the low voltage circuit will be exemplified by an $I^2L$ circuit, although the invention is not limited to this $I^2L$ circuitry has the advantageous features of easy compatibility with hitherto known bipolar elements possibility of being implemented at a high integration density and capability of a low power dissipation operation at a low voltage (in the range of 0.5 to 1.5 V) and a low current. Thus, $I^2L$ circuit enjoys popularity in numerous applications.

As the range of applications of $I^2L$ circuits is expanded, the number of gates which can be integrated in a single chip is also increased. The increase in the number of gates leads to a proportional increase in the total current consumption to such a level that the $I^2L$ circuits take a large proportion of the power consumed in the whole chip, despite the low power consumption of each $I^2L$ circuit. Under these circumstances, there is a demand to decrease further the power consumption of $I^2L$ circuits.

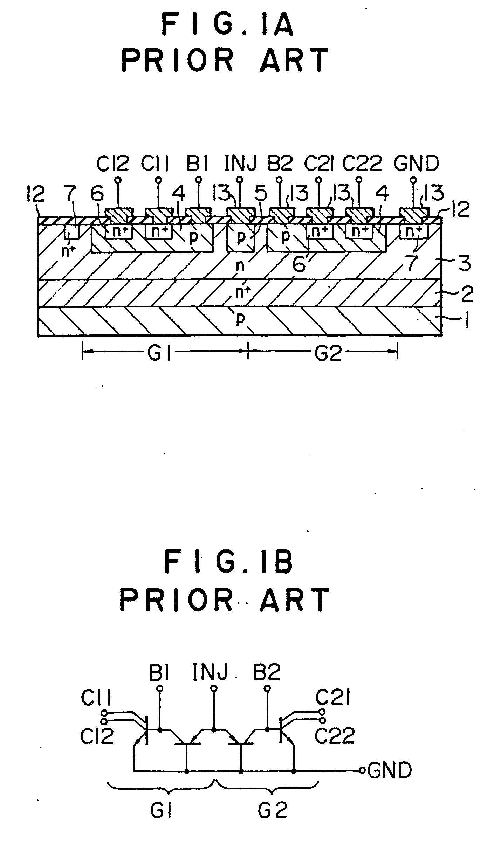

The structure of an $I^2L$ circuit is in substance identical to that of a bipolar transistor. Fig. 1A of the accompanying drawings illustrates $I^2L$ circuitry having two gates G1 and G2, while Fig. 1B shows an equivalent circuit of the device shown in Fig. 1A. Referring to Fig. 1A, a Si-substrate 1 of p-type conductivity, has thereon a buried layer 2 of $n^+$-type conductivity. A Si-epitaxial layer 3 of n-type conductivity is formed on the buried layer 2. Also shown are p-type base regions 4 of the $I^2L$ or collector regions of lateral type pnp-transistors, a p-type injector region 5 of the $I^2L$ or emitter region of the lateral pnp-transistor, n-type collector regions 6 of the $I^2L$, $n^+$-regions 7 connected to the ground line, an insulation film 12, and electrodes 13. It will be seen that the $I^2L$ circuit is constituted by the upside-down vertical npn-bipolar transistor 3 (2), 4 and 6 and the lateral pnp-bipolar transistor 5, 3 (2) and 4 and differs from a known bipolar transistor circuit in that the epitaxial layer 3 which serves as the collector of the conventional npn-transistor is used as the emitter while the diffusion layer 6 used heretofore as the emitter serves as the collector. Also the pnp-transistor and the npn-transistor are so integrated and merged that the collector of the pnp-transistor and the base of the npn-transistor are merged in the same diffusion layer 4. Moreover, the base of the pnp-transistor serves additionally as the emitter of the npn-transistor. In the $I^2L$ circuit of this configuration, the pnp-transistor merges with the npn-transistor, so that holes may be injected from the emitter 5 of the common-base pnp-transistor. Thus, the emitter of the pnp-transistor is referred to as the injector of the $I^2L$ circuitry.

As can be seen from Figs. 1A and 1B, the $I^2L$ circuit brings about advantages as follows:

(1) By virtue of the arrangement in which the epitaxial layer serves as an emitter region, a deep isolation region for isolating the npn-transistors is unnecessary, thereby permitting a significantly increased integration density.

(2) Since the lateral (pnp) transistor merges with the vertical (npn) transistor, the integration density can be increased.

(3) Implementation of a single gate solely by integrated pnp- and npn-transistors permits a low power operation in combination with the fact that the supply voltage may be sufficiently low to operate only a single diode.

Because of the advantageous features described above, $I^2L$ circuits are used in many integrated circuits.

If the configuration of integrated circuits including $I^2L$'s for practical applications are examined, it will be found that there are few integrated circuits which are formed solely from $I^2L$'s but a major proportion of $I^2L$ chips is normally occupied by integrated circuits in which $I_2L$ is employed in combination with other logic circuits and analogue circuits. An integrated circuit of the latter type is usually operated by using an source voltage of 3 to 30 volts which is obviously higher than the operation voltage of the $I^2L$.

Hitherto, in an integrated circuit in which $I^2L$ circuits coexist with other circuits which require higher operation voltages, the power consumption or dissipation of the $I^2L$ occupies only a small part of the power dissipation of the whole integrated circuit. Generally, the current consumption of the $I^2L$ for a single gate is usually in the range of several micro amperes to 100 μA. On the other hand, the current consumption of other circuits and in particular that of an analogue circuit lies in most cases in a range of several hundred microamperes to several milliamperes. Early $I^2L$ circuits, which incorporated therein a relatively small number of gates, involved substantially no serious problem as to power consumption. However, the rapid development of $I^2L$ circuit technology which allows the number of gates integrated in an $I^2L$ configuration to be significantly increased has resulted in the development of integrated circuits which can incorporate 1000 or more gates implemented by $I^2L$ circuits. These integrated circuits demand a large current for operation, even at low voltage. To meet such a demand, the use of the conventional power supply, e.g. rated 5 to 30 volts, is not preferred in view of the poor efficiency involved. It may also be noted that in an integrated circuit which includes an increased number of gates in the $I^2L$ configuration, other circuits provided in coexistence with the $I^2L$ gates tend to be implemented on a larger and larger scale in order to achieve correspondingly complicated functions, which means that the power consumption or dissipation of the integrated circuit on the whole tends to increase.

An example of a semiconductor integrated circuit in which a low voltage operation circuit and a high voltage operation circuit (a circuit which operates at a higher voltage than the low voltage operation circuit) are implemented in coexistence in the same integrated circuit is disclosed in JP—A—54—117674. This document therefore corresponds to the pre-characterising part of claim 1.

The present invention seeks to reduce the power consumption of such a circuit and is characterised in that low voltage operation circuit is inserted in a current path of said high voltage operation circuit through which path a substantially constant current flows so that said high voltage operation circuit serves as a current supply source for said low voltage operation circuit in addition to other functions and operations inherent to said high voltage operation circuit, thereby to allow the current which flows through said high voltage operation circuit also to flow through said low voltage operation circuit.

In this way the current for the high voltage operation circuit also flows through the low voltage operation circuit, such as an I²L circuit. The present invention also permits the area of semiconductor chip occupied by the integrated circuit to be reduced.

Embodiments of the invention will now be described in detail, by way of example, with reference to the accompanying drawings in which:

Figs. 1A and 1B are views illustrating the structure of an I²L circuit, and have already been discussed;

Figs. 2A, 2B, 3A, 3B, 4, 5, 6 and 7 are views showing various circuits having constant current paths, adapted to be hybridized with IIL circuits;

Figs. 8A to 28B are views illustrating various embodiments of the invention;

Figs. 29A, 29B and 29C are views illustrating a hitherto known circuit in which an I²L circuit is incorporated in coexistance with an analogue circuit or the like;

Figs. 30A, 30B, 31A, 31B and 32 are views illustrating circuits which incorporate I²L circuits in combination with analogue or the like circuits according to the teachings of the present invention;

Figs. 33A, 33B, 34A and 34B are views to illustrate configurations of CSTL circuits; and

Figs. 35A and 35B are views illustrating an example of a circuit incorporating I²L circuits and a CSTL circuit in combination according to another embodiment of the invention.

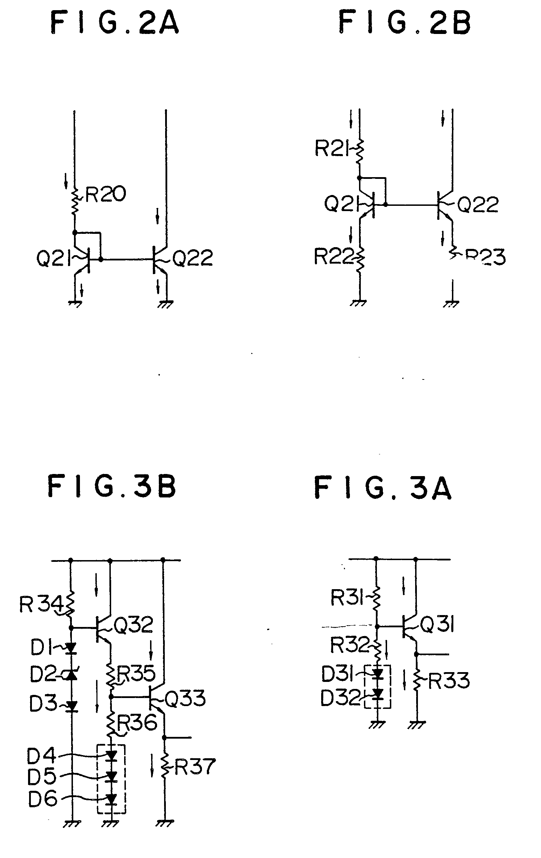

When circuits which are provided in combination or in hybridization with I²L circuits are examined in detail, it will be found that there are many parts of the circuit through which no signal currents flow, but through which constant currents or D.C. currents flow. The power consumed in these constant current circuit parts is of significant amount. Typical examples of such circuits are illustrated in Figs. 2A to 7.

Referring to these Figures, emitter paths of transistors Q21 and Q22, paths extending through resistor R20 or R21 and collector paths of the transistor Q22 constitute respective constant current paths. These paths serve to supply bias currents to other parts of the circuit and determine the operational point of the circuit. In essence, these currents are loss or wastage currents. In Figs. 2A and 2B and the following figures, the constant current paths through which substantially constant currents flow are indicated by arrows "↓".

Figs. 3A and 3B show typical examples of constant voltage source circuits each adapted to supply a constant voltage to other parts of the circuit. In the circuit shown in Fig. 3A, the base voltage of a transistor Q31 is substantially constant, and the current flowing through diodes D31 and D32 is also constant. Also, the collector current of the transistor Q31 and the current flowing through a resistor R33 is also substantially constant. These currents constitute biases for determining the output voltage. In the case of the circuit shown in Fig. 3B, substantially constant currents flow through current paths constituted by resistors R35 and R36 and diodes D4, D5 and D6, collector paths of transistors Q32 and Q33 and a current path extending through a resistor R37, respectively. These currents constitute biases for determining the constant voltage output.

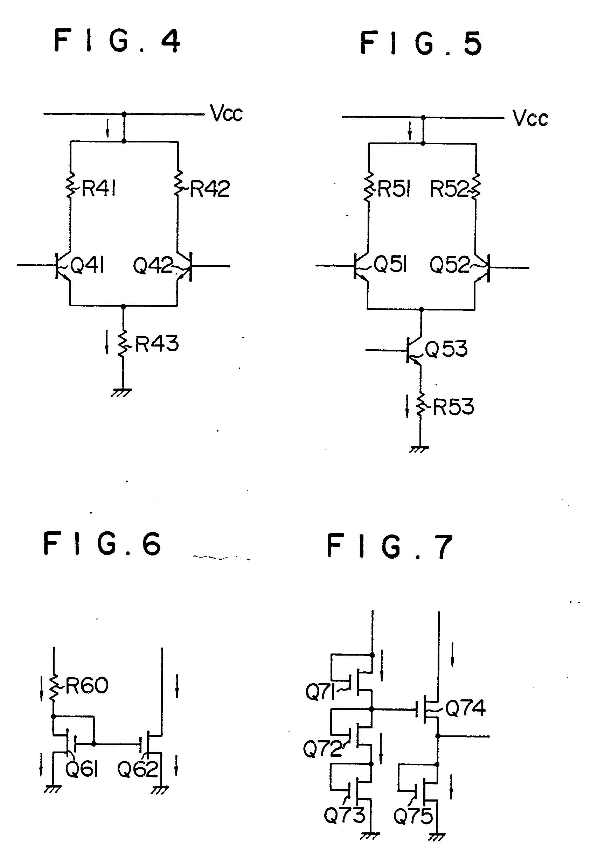

Fig. 4 shows a typical example of a differential amplifier. Although emitter currents of transistors Q41 and Q42 of this circuit are not constant, the sum of the emitter currents of these transistors Q41 and Q42 is constant, so that the current flowing through a resistor R43 and the current flowing through a current path formed between a voltage supply source Vcc and the point of interconnection of resistors R41 and R42 is substantially constant.

Fig. 5 shows another example of a differential amplifier, which is similar to the one shown in Fig. 4. In the case of this circuit, the sum of emitter currents of transistors Q51 and Q52 is made constant by a transistor Q53. Accordingly, the current flowing along a path including a resistor R53 and the current flowing along a current path formed between a voltage supply source Vcc and the point of interconnection between resistors R51 and R52 is also constant.

Fig. 6 shows an example of a constant current source circuit constituted by insulated-gate field effect transistors (hereinafter referred to as MOS transistors). In this circuit, drain currents and source currents of MOS transistors Q61 and Q62 are constant, as is in the case of the circuits shown in Figs. 2A and 2B. In the figure, a load through which a constant bias current flows is indicated by resistor R60.

Fig. 7 shows an example of a constant voltage source circuit constituted by MOS transistors. A constant current flows through MOS transistors Q71, Q72 and Q73. Further, a constant current flows through a MOS transistor Q75 with the drain current of a MOS transistor Q74 being constant. These constant currents constitute bias currents for forming the output voltage.

In some integrated circuits, the total current in an analogue circuit is of the order of 22 mA and the current flowing through bias ciruits such as those mentioned above amount to 11.3 mA, say, 50% or more of the current flowing in a whole analogue circuit.

Therefore, a circuit according to the present invention, in which a low voltage circuit or circuits which operates with a constant current is inserted in a constant current path of the high voltage circuit exemplified above; permits the use of a low operating voltage, and thus enables substantial use of the above-mentioned circuit configuration in semiconductor integrated circuits.

For example, an IIL circuit requires a supply voltage of only about 0.5 about 1.5 volts, such IIL circuits can be inserted into semiconductor integrated circuits having rated supply voltages of the order of 3 to 15 volts, without requiring a substantial increase in the supply voltage. In order to prevent increase of the supply voltage, the operation voltage of the low voltage circuit is preferably at most one half of the supply voltage of the semiconductor integrated circuit. Usually, the ratio of the operation voltage of the low voltage circuit to the supply voltage of the integrated circuit is between about 1/3 and about 1/15. A plurality of low voltage circuit stages connected in series may also be inserted in a high voltage circuit. In such a case, the number of serially inserted stages should be determined by consideration of the operating voltages of the low voltage circuit and the supply voltage for the integrated circuit.

IIL circuits are preferred examples of the low voltage circuit. However, any low voltage circuit which can operate at an operating voltage at most equal to about one half of the supply voltage for the semiconductor integrated circuit may be used efficiently in the present invention. The circuit configuration suppresses an increase in the supply voltage and the efficiency of the power consumed in a semiconductor integrated circuit may be improved. Thus, it is wasteful to leave the bias currents flowing unused.

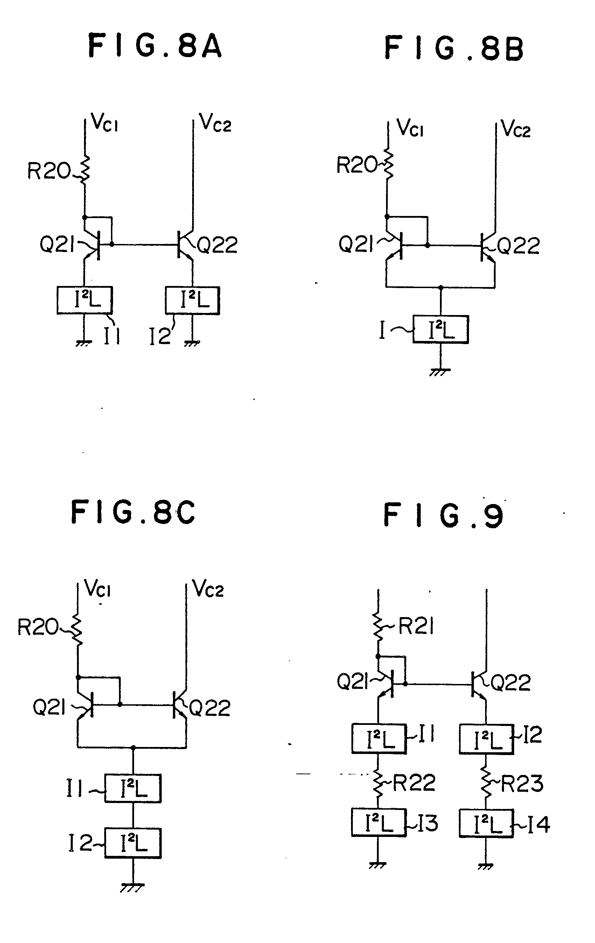

Figs. 8A, 8B and 8C illustrate constant current source circuits in each of which the arrangement is such that the current can be utilized effectively, i.e. with less wastage or loss. As described above with reference to the constant current circuits shown in Figs. 2A and 2B, the emitter currents of the transistors Q21 and Q22 of the respective circuit configurations are substantially constant. For this reason, it is possible to insert a I²L circuit or circuits between the ground or earth and the emitter electrodes of the transistors Q21 and Q22 in the respective circuits as indicated by I, I1 and I2. In Fig. 8A, each IIL circuit is connected between the emitter electrode of each transistor and the ground. In Fig. 8B, an IIL is connected between the interconnection of the emitter electrodes and the ground. In Fig. 8C, two IIL circuits are stacked in series. Each of the I²L circuits may correspond to the one shown in Figs. 1A and 1B. In Figs. 8A and 8B, the injector terminals of the I²L circuits are connected to the respective emitter electrodes or the common emitter electrode of the transistors Q21 and Q22, while the ground terminals of the I²L circuits are connected to the inherent ground terminals of the constant current source circuit. Since a pn-junction exists between the injector terminal and the ground terminal of the I²L circuits, a voltage (of about 0.7 volts) is produced across these terminals, which corresponds to the forward voltage drop of a diode. Accordingly, the emitter potentials of the transistors Q21 and Q22 of the constant current source circuits illustrated are higher than those of similar known circuits by the forward voltage drop of a diode. Since the supply voltage Vc1 and the the collector voltage Vc2 of the transistor Q22 are usually selected to be higher than the forward voltage drop of a diode, insertion of an I²L circuit or circuits in the emitter paths of the transistors Q21 and Q22 will involve no significant problems.

As an alternative to providing a single I²L circuit block, as in the case of the circuit shown in Figs. 8A and 8B, it is possible to provide two blocks of the I²L circuits as shown in Fig. 8C or to stack three or more I²L circuits (stacked IIL circuits may be seen, for example, in JP—A—78268 of 1975).

According to the circuit arrangements shown in Figs. 8A, 8B and 8C, the bias currents can be utilized effectively for the operation of the I²L circuits. Such utilization becomes more effective by stacking two, three or more I²L circuit blocks which further reduces the wasted part of the supply voltage in the bias circuit.

Fig. 9 shows another embodiment of the invention, according to which I²L circuits are inserted in emitter current paths of a constant current source circuit, as indicated by I1, I2, I3 and I4. In this embodiment, the I²L circuits may be inserted between the emitter electrodes of the transistors Q21 and Q22 and resistors R22 and R23, respectively, as in the case of the I²L circuits I1 and I2, or alternatively or additionally the I²L circuits I3 and I4 may be interposed between the ground and the resistors R22 and R23, respectively. Further, instead of connecting the I²L circuits separately to the lower potential ends of the resistors R22 and R23, it is also possible to connect together these low potential ends of the resistors R22 and R23 and interpose a cascaded stack of I²L circuits (I3 and I4) between the connected end of those resistors and the ground.

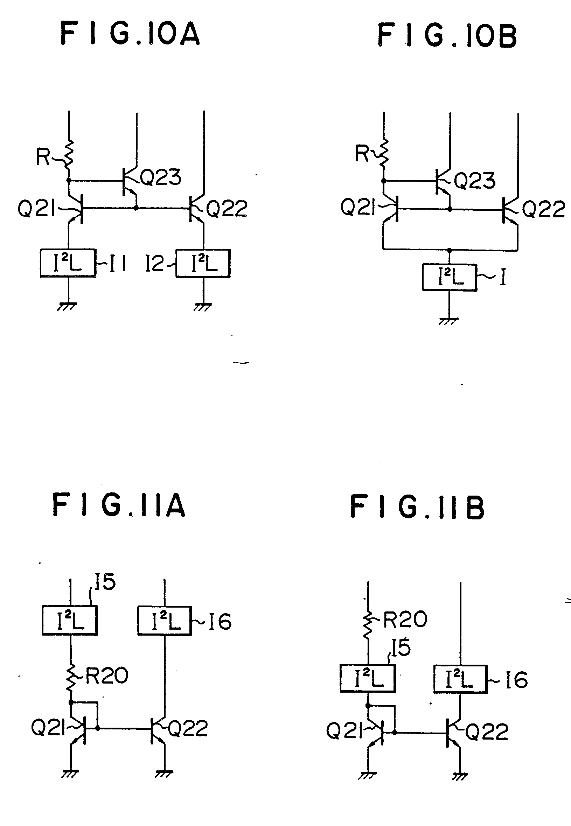

Figs. 10A and 10B show further embodiments of the invention applied to another type of constant current source circuit. From these figures, it will be readily seen that the I²L circuit (I) or circuits (I1, I2) are connected in the emitter paths of the transistors Q21 and Q22 in a manner similar to the circuit configuration shown in Figs. 8A, 8B, 8C and Fig. 9.

Similar advantages as those mentioned above with reference to the embodiments shown in Figs. 8A, 8B and 8C can also be attained in the embodiments shown in Figs. 9, 10A and 10B.

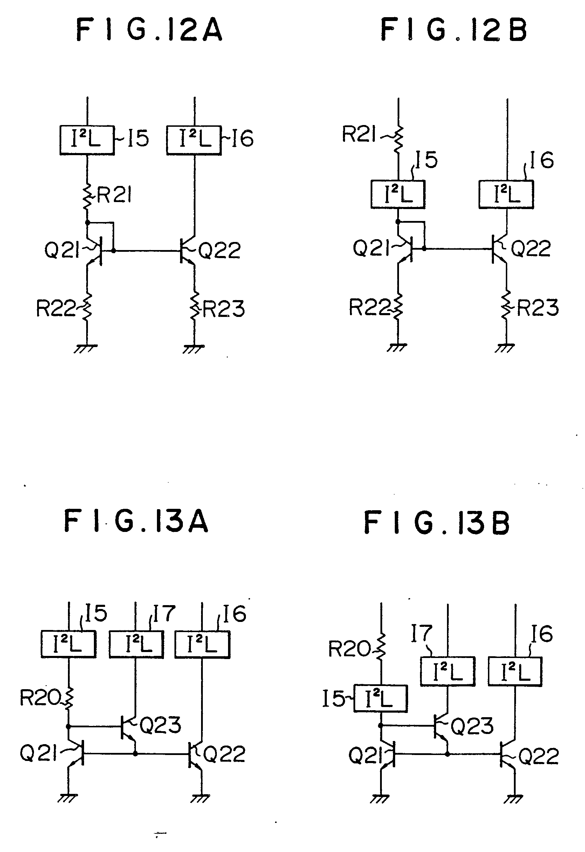

Figs. 11A, 11B, 12A, 12B 13A and 13B show circuit arrangements according to further embodiments of the invention, in which the I²L circuits (I5, I6, I7) are inserted in collector paths of the transistors Q21 and Q22, respectively. Although both the I²L circuits I5 and I6 are shown to be inserted in the respective collector paths, it is also possible to provide only one of these I²L circuits. Further, referring to Figs. 13A and 13B, another I²L circuit 17 may also be used.

Insertion of the I²L circuits in the collector paths of the transistors Q21 and Q22, respectively, is possible for the same reason as mentioned above in conjunction with the insertion of I²L circuits in the emitter paths, respectively, i.e. because the collector currents are constant. The IIL circuit may include a level shift circuit when required for coupling to other circuits.

Furthermore, the embodiments shown in Figs. 11A, 11B, 12A, 12B, 13A and 13B bring about significant advantages, as will be discussed below.

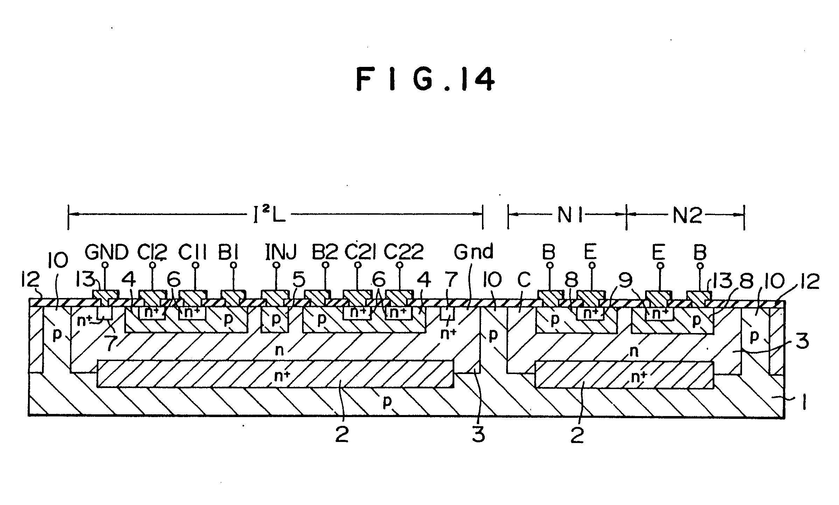

In one known integrated circuit, illustrated in Fig. 14, conventional npn-transistors N1 (and N2) and the I²L circuitry are isolated from each other by a diffusion layer 10 of a suitable depth. An n-type well 3 contains p-type regions 8 and n⁺-type regions 9 which form two transistors N1 and N2 isolated from the I²L block in another n-type well. This integrated circuit can be fabricated with the aid of the isolation layer. As a matter of fact, however, the formation of the isolation layer occupies a relatively large area of the chip containing the integrated circuit element and hence limits the packing density. In particular, when a circuit component exhibiting a high breakdown voltage is wanted, a thick epitaxial layer 3 is used to provide a high breakdown voltage. Then, the isolation region which should penetrate through the epitaxial layer is inevitably deep. In this case, the isolation region not only diffuses depthwise of the epitaxial layer but also diffuses laterally over a substantially similar distance to the depthwise diffusion in the epitaxial layer. Accordingly, adequate margins have to be preserved between the respective circuit components and the isolation diffusion, which means that area of the chip carrying the integrated circuit element is correspondingly increased. The area of the chip in which the integrated circuit is fabricated can be reduced as the number of the insolation regions provided between respective circuit components is reduced.

In this connection, reference is again made to Figs. 11A and Fig. 13B showing circuit arrangements in which I²Ls are inserted in the collector paths of the conventional npn-transistors. Then, as shown in e.g. Fig. 11A, the collector electrode of the transistor Q22 is at the same potential as the ground terminal of the associated I²L circuit I6.

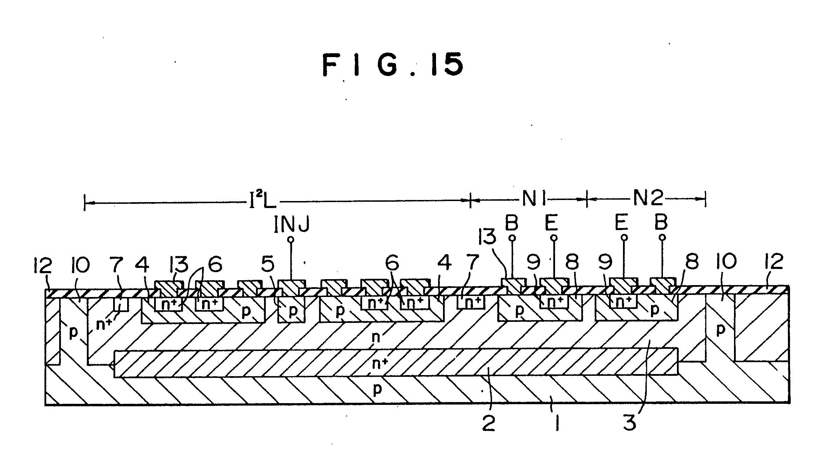

Accordingly, it is possible to fabricate both transistor Q22 and the I²L circuit I6 in the same isolated region 3 as illustrated in Fig. 15. In Figs. 14 and 15, one of the transistors N1 and N2 can be used as the transistor Q22 and the other transistor for another purpose. Thus, no isolation region is required between the transistor N1 or N2 and the I²L circuit, which is different from the known structure shown in Fig. 14. In this way the area of the chip carrying the integrated circuit can be significantly reduced.

When an I²L circuit and a transistor for other uses are implemented in the same isolation region, a problem may arise depending on the circuit configuration adopted. A parasitic lateral pnp-transistor may be formed with a base constituted by the n-type epitaxial layer 3 between the p-type base 4 or the p-type injector 5 of the npn-transistor of the I²L circuit and the p-type base 8 of the usual npn-transistor, whereby parasitic thyristor operation may take place due to the co-operation of the parasitic pnp-transistor and the usual npn-transistor. The n⁺-type diffusion 7 between the p-type regions 4 and 8 reduces the occurrence of such parasitic transistor.

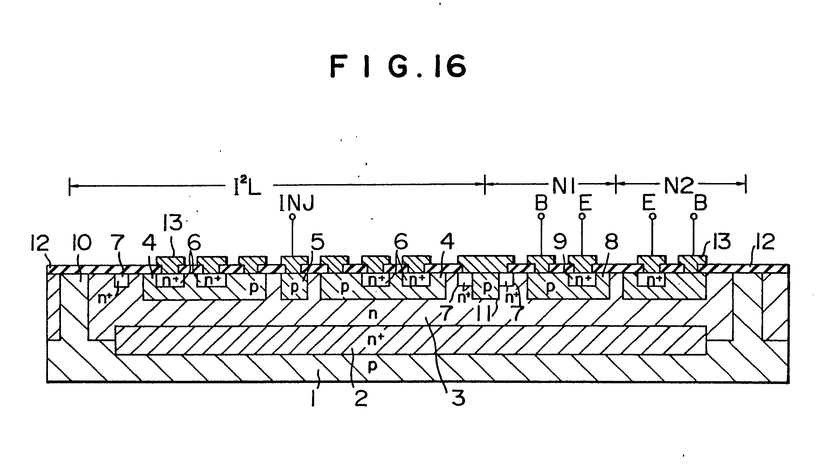

An embodiment of the invention which is also intended to prevent such parasitic thyristor operation is illustrated in Fig. 16. As can be seen from the figure, a p-conductivity type semiconductor region 11 of a relatively small depth with respect to the epitaxial thickness is provided between the I²L circuit and the npn-transistor N1 and connected to the epitaxial layer 3 through the n⁺-type region 7 so that holes injected into the epitaxial layer 3 from the base 4 of the I²L circuit or the base 8 of the npn-transistor can be absorbed. The p-region 11 and the n⁺-region 7 may be formed simultaneously with the formation of other regions.

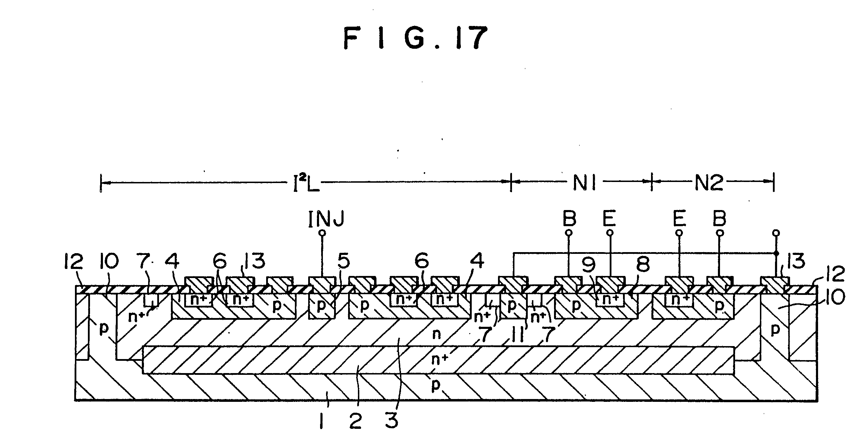

Fig. 17 shows another embodiment of the invention provided with means for preventing parasitic thyristor operation. As in the case of the structure illustrated in Fig. 16, a p-conductivity type semiconductor region 11 of relatively small depth is formed between the I²L circuit and an npn-transistor. In this embodiment, however, this region 11 is connected to the semiconductor substrate 1. This structure also attains effects similar to the structure shown in Fig. 16.

For the structures shown in Figs. 16 and 17, it is to be noted that the p-conductivity type semiconductor layer 11 formed between the I²L circuit and the npn-transistor N1 can be achieved satisfactorily by a semiconductor region having a shallow junction, thus making it unnecessary to reserve a large distance between the I²L and the transistor N1, differing from the structure shown in Fig. 14 where the isolation layer 10 of a great depth is used. Hence an increased integration density can be attained as compared with the known device illustrated in Fig. 14.

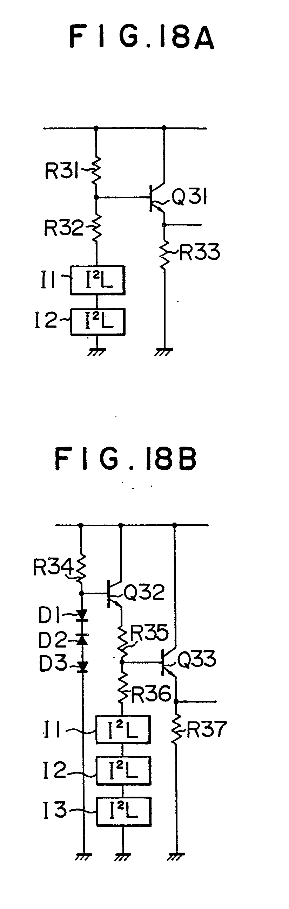

Figs. 18A and 18B show circuit diagrams of constant voltage source circuits according to further embodiments of the invention in which I²L

circuits (I1, I2, I3) are inserted in the base bias paths of output transistors.

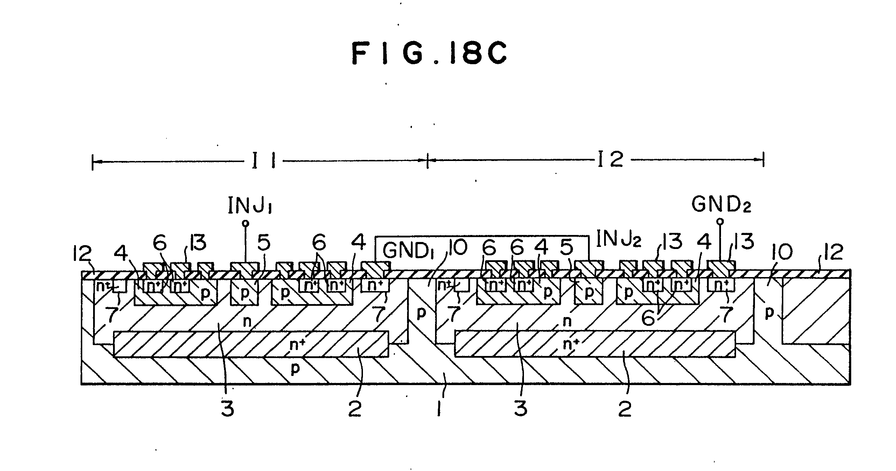

As will be seen from the known circuit configurations shown in Figs. 3A and 3B, the base circuit of the transistor Q31 or Q33 is often provided with a resistor and diodes for determining the base bias voltage. In this case, a substantially constant current flows through the resistor and the diodes. Thus, the invention also teaches that the diodes be replaced by an I²L circuit thereby to utilize effectively the current which, previously has been left flowing wastefully in the bias circuit. When a plurality of the I²L circuits or blocks are stacked in series and inserted in place of the diodes (see Figs. 3A and 3B), the current can be utilized more effectively. By way of example, a number of I²L gates, as required, may be divided into two I²L blocks or circuits I1 and I2, as shown in Fig. 18A, wherein the injector terminal of the I²L circuit I1 is connected to the resistor R32 while the ground terminal thereof in turn is connected to the injector terminal of the I²L circuit or block I2. The ground terminal of the I²L circuit I2 is connected to the ground terminal of the integrated circuit. When the current required for the operation of all the I²L circuits is represented by Io, this current can be reduced to one half (i.e. Io/2) by stacking two divided I²L circuits or blocks in the manner mentioned above. Stacking of I²L circuits in practical applications can be accomplished by isolating the I²L circuits I1 and I2 from each other by providing respective isolation regions in the integrated circuit, as shown in Fig. 18C.

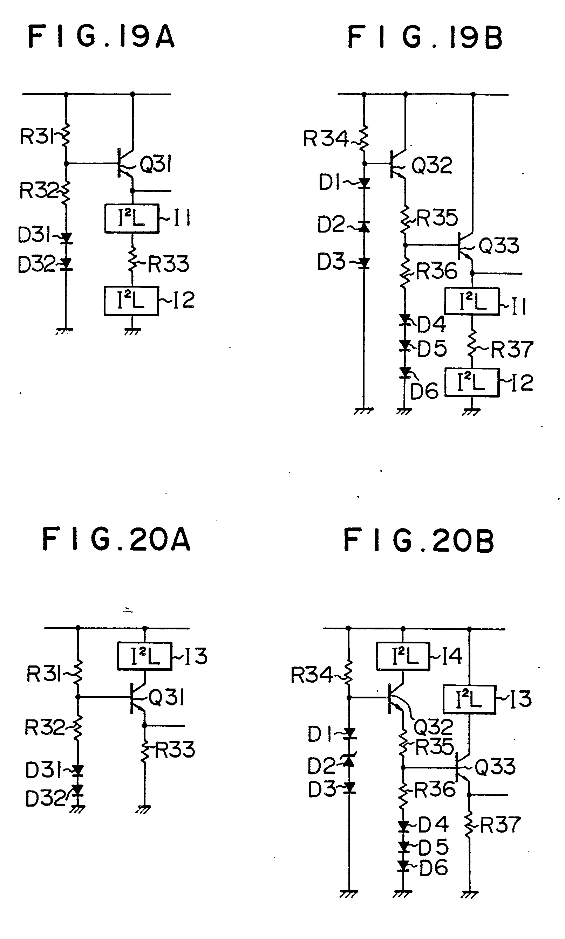

Figs. 19A and 19B show further embodiments of the invention in which I²L circuits are stacked in series and are inserted in the emitter path of a transistor of a constant voltage source circuit. Each of the transistors Q31 and Q33 has an emitter path of constant voltage. Accordingly, the currents flowing through resistors R33 and R37 are each constant. Thus, it is possible (and advantageous) to insert the I²L circuits I1 and I2 in each emitter path. Of course, only one of the I²L circuits I1 and I2 can be inserted instead of both.

Figs. 20A and 20B show constant voltage source circuits according to further embodiments of the present invention in which a transistor or ·transistors constituting the constant voltage source have respective collector paths each provided with an I²L circuit or circuits (I3; I3, I4). Since the collector current of the transistor Q31 of the constant voltage source circuit shown in Fig. 20A, and the collector currents of the transistors Q32 and Q33 constituting the constant voltage source circuit of Fig. 20B, are individually constant, it is possible (and preferable) to insert the I²L circuit or circuits in the collector path or paths of the transistor Q31 or transistors Q32 and Q33. Only one of the I²L circuits I3 and I4 can be inserted instead of both, in the case of the circuit shown in Fig. 20B. These embodiments also have the advantage that the I²L circuit and the associated transistor can be in the same isolation region, in the same manner as previously described for the embodiments shown in Figs. 15, 16 and 17.

Each of the I²L circuits in the embodiments shown in Figs. 19A, 19B, 20A and 20B may also have stacked stages connected in series, as for the embodiments shown in Figs. 18A and 18B.

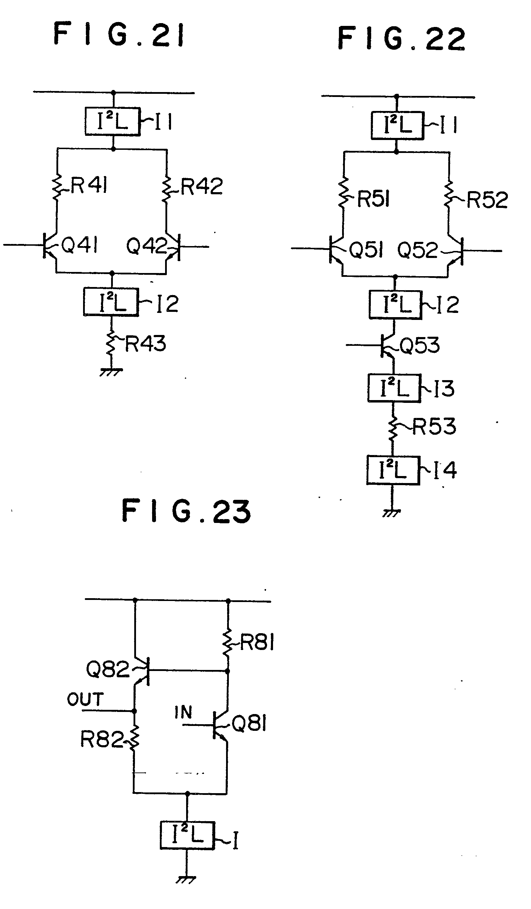

Figs. 21 and 22 show examples of a differential amplifier circuit to which the invention is applied. As described previously with reference to Figs. 4 and 5, the current path extending from the interconnection between the emitter electrodes of the differential transistors Q41 and Q42 or the interconnection between the emitter electrodes of the differential transistors Q51 and Q52 and the current path extending from the interconnection between the resistors R41 and R42 or the interconnection between the resistors R51 and R52 conduct respective constant currents. Accordingly, it is possible (and advantageous) to insert the I²L circuits (I1 and I2) in these current paths, respectively. In the circuit shown in Fig. 21, either the I²L circuit I1 or I2 may of course be omitted. Further, only one of the I²L circuits I1, I2, I3 and I4 of the differential amplifier circuit shown in Fig. 22, may be provided, with the other three being omitted. In brief, it is possible to insert an I²L circuit or circuits at circuit portions of the differential amplifiers where the total current remains constant or undergoes only slight variations even when the currents flowing through the individual transistors may vary greatly with the passage of time.

Fig. 23 shows another embodiments of the invention in which an I²L circuit is employed in a circuit in which mutual current compensation takes place. Referring to the figure, when the input potential IN of a transistor Q81 goes high, the collector potential of the transistor Q81 is lowered thereby to increase the emitter current thereof. The collector electrode of the transistor Q81 is connected to the base electrode of another transistor Q82, so that the lowering of the collector potential of the transistor Q81 is accompanied by lowering of the emitter potential of the transistor Q82. This causes a decrease in the emitter current of the transistor Q82. The emitter currents $I_{E1}$ and $I_{E2}$ can be given by the following expressions, respectively:

$$I_{E1} = \frac{Vcc - Vc}{R}$$

$$I_{E2} = \frac{Vc - V_{BE}}{R}$$

where Vcc represents a source voltage, Vc represents the collector potential of the transistor Q81, and $V_{BE}$ represents a voltage drop (i.e. diode voltage) which appears between the base and emitter electrodes of the transistor Q82 and is substantially constant. Accordingly, the sum of the emitter currents of both transistors Q81 and Q82 is constant, as can be seen from the following expression.

$$I_{E1}+I_{E2}=\frac{V_{CC}-V_{BE}}{R}$$

Thus, it is possible to insert an $I^2L$ circuit in the arrangement shown in Fig. 23. More generally, any circuit composed of a transistor corresponding to Q81 and a load resistor corresponding to R81 as shown in Fig. 23 may be provided with a current compensating circuit in the manner as illustrated in Fig. 23 so as to enable insertion of $I^2L$ circuits at various circuit points in such a circuit. It will thus be appreciated that the circuit arrangement shown in Fig. 23 serves merely for the purpose of illustration, and the fundamental concept of this embodiment can be applied equally to other circuits, in which a constant current flowing through an IIL circuit may be divided into mutually compensating currents, and at least one of them be used in a high voltage circuit.

In the case of the embodiments illustrated in Figs. 21, 22 and 23, the $I^2L$ circuit may be divided into a given number of blocks which are then connected in the stacked configuration, as described above.

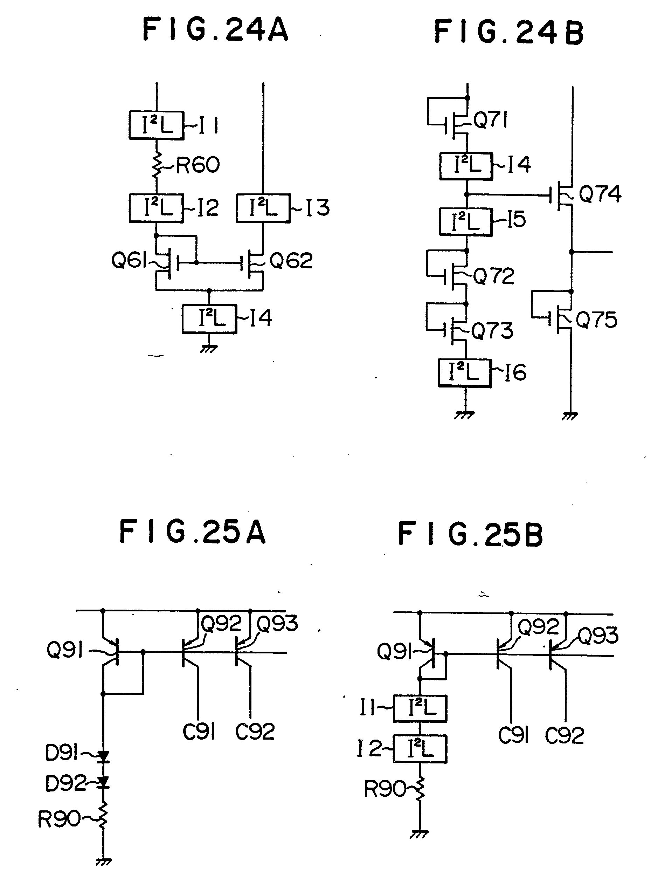

Figs. 24A and 24B show circuits according to further embodiments of the invention in which MOS transistors are used.

Referring to Fig. 24A, the $I^2L$ circuits I1, I2, I3, I4 are provided in a constant current source circuit constituted by MOS transistors Q61 and Q62. As described above with reference to the conventional constant current source circuit shown in Fig. 6, the respective drain currents, and the source currents of the MOS transistors Q61 and Q62, are constant. Thus the $I^2L$ circuit or circuits may be inserted in any one of the associated constant current paths. Fig. 24B shows a constant voltage source circuit constituted by MOS transistors Q74 and Q75 with the $I^2L$ circuit or circuits I4, I5 and/or I6 being inserted in the constant current path. As described above with reference to Fig. 7, the gate bias path of the MOS transistor Q74 composed of MOS transistors Q71, Q72 and Q73 conducts a substantially constant current. Thus, the $I^2L$ circuit or circuits (I4, I5 and/or I6) may be inserted in this base current path. In this embodiment, it is also possible that the $I^2L$ circuit may be divided into a given number of blocks which are then connected in the stacked configuration.

Fig. 25A shows a known constant current source circuit constituted by pnp-transistors. An $I^2L$ circuit or circuits for this may be provided in the arrangement shown in Fig. 25B, as for a constant current source circuit constituted by npn-transistors.

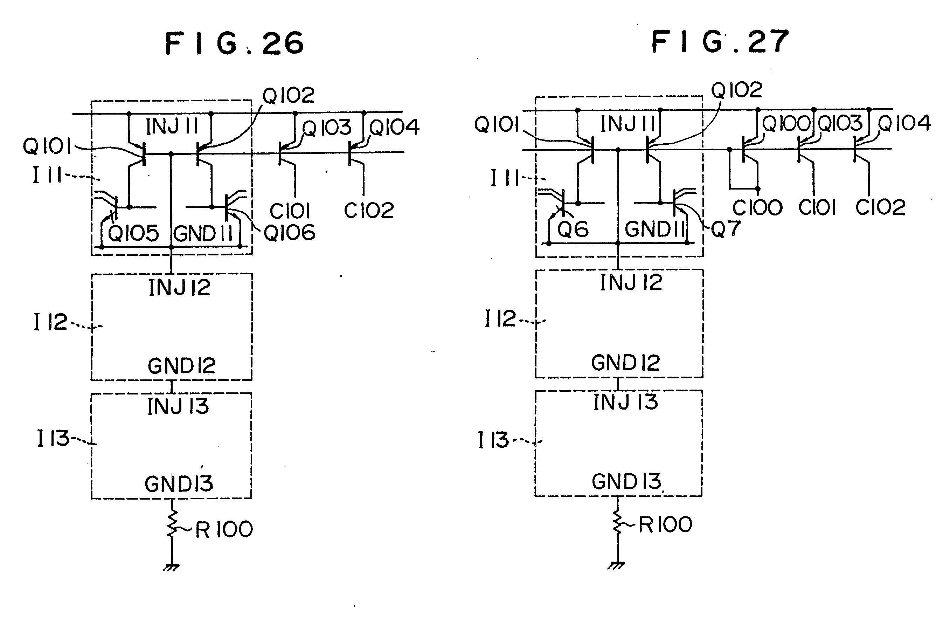

Insertion of the $I^2L$ circuit or circuits into the constant current source circuit constituted by the pn-transistors is also very advantageous in that the area of the integrated circuit element can be significantly reduced. Figs. 26, 27, 28A and 28B show examples of such constant current source circuits.

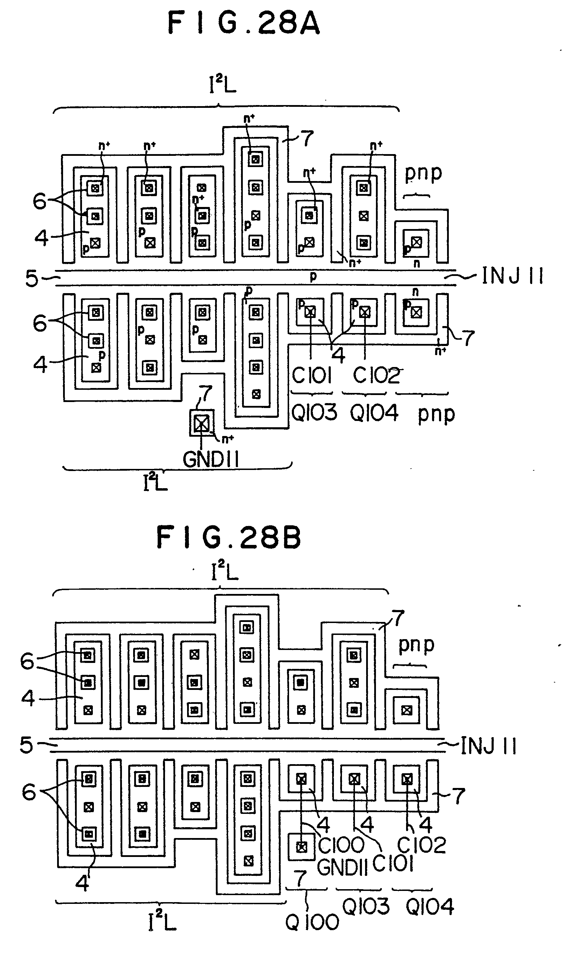

Figs. 26 and 27 show constant current source circuits constituted by pnp-transistors in a known manner, wherein an $I^2L$ circuit is formed in an isolated epitaxial region serving as the base of a pnp-transistor. Symbol R100 represents a load element. In the case of the circuit arrangement shown in Fig. 26, the constant currents flowing through collector electrodes C101 and C102 of the transistors Q103 and Q104, respectively, are determined solely by the $I^2L$ circuits I11, I12 and I13. On the other hand, Fig. 27 shows a structure in which the collector electrode C100 of one pnp-transistor Q100 is connected to the base electrode thereof thereby to ensure stablised collector constant currents from the collector electrodes C101 and C102 of the transistors Q103 and Q104, respectively. In both embodiments shown in Figs. 26 and 27, the injector terminals INJ 11 of the the $I^2L$ circuits also serve as the emitter electrodes of the pnp-transistors Q100, Q103 and Q104 which supply constant currents. Since the $I^2L$ circuit of the first block I11 has a common ground line GND11 which is connected in common to the base electrodes of the pnp-transistors Q100, Q103 and Q104, the $I^2L$ circuits of the first block I11 can be formed in the isolated regions of the pnp-transistor Q100, Q103 and Q104. Fig. 28A shows in a plan view a layout pattern for the integration of the circuit shown in Fig. 26, while Fig. 28B shows in a plan view a layout pattern for the integration of the circuit shown in Fig. 27. As can be seen from Figs. 28A and 28B, the emitter electrode of the current-supplying pnp-transistor can be used in common as the injectors INJ11 of the $I^2L$ circuit, thus allowing the pnp-transistor and the $I^2L$ circuit to be close to each other, without an isolation layer therebetween. Thus, integration can be accomplished at a high packing density.

In the foregoing, description has been made of characteristic features and advantages of the invention applied to various circuits. Next, features and advantages of the invention applied to practical integrated circuits will be discussed in the light of the integrated circuit structure taken as a whole.

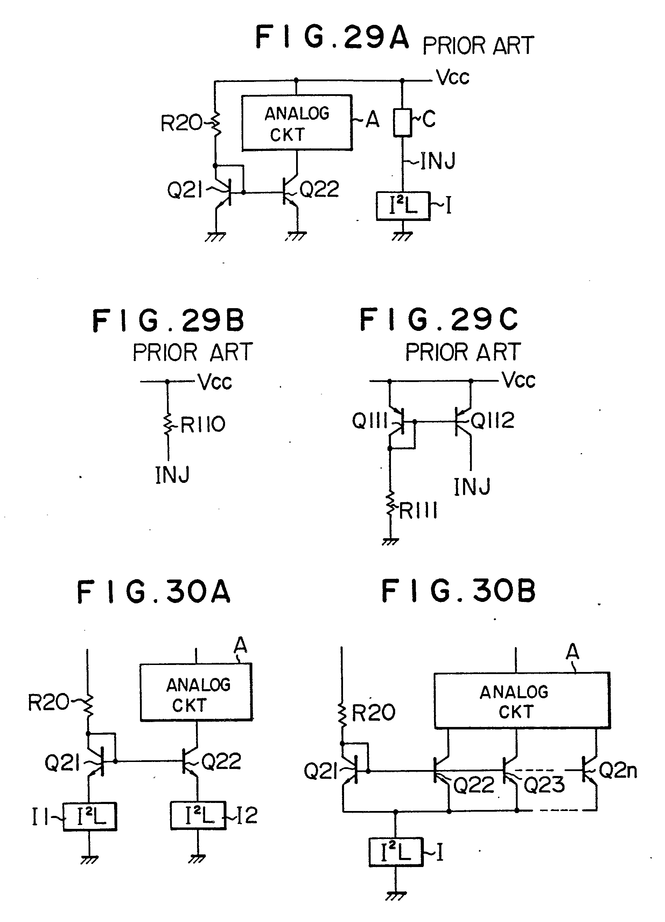

Figs. 29A, 29B and 29C schematically illustrate current supply to an $I^2L$ circuit incorporated in an integrated circuit. In a conventional integrated circuit, the $I^2L$ circuit (I) and other circuits such an analogue circuit (A) are implemented independent of each other, as is illustrated in Fig. 29A. Such an arrangement is disclosed in JP—A—54—117674. The current supply to the $I^2L$ circuit at the injector terminal thereof is achieved by a constant current element denoted by a letter C in Fig. 29A. The constant current element C is usually a resistor R110 as shown in Fig. 29B or alternatively may be pnp-transistors Q111 and Q112 as shown in Fig. 29C. With such a circuit arrangement, it is necessary to supply separate currents to the analogue circuit and to the $I^2L$

circuit, involving a significantly large current consumption as a whole.

In contrast, the present invention teaches that the I²L circuits (I1, I2 or I) are inserted in the current paths of the conventional analogue or other circuits, thereby to obviate the necessity of supplying a current to the I²L circuits, as is illustrated in Figs. and 30B. Thus, the power consumption or dissipation of the whole integrated circuit can be reduced significantly. Fig. 30A illustrates a circuit in which I²L circuits are inserted in constant current paths. Since there exist numerous constant current locations in a given integrated circuit, it can be said that a great number of current supply sources are available for all the I²L gates incorporated in the integrated circuit.

In the case of the integrated circuit shown in Fig. 29A, a current of 22mA inclusive of signal current is consumed by all the analogue circuits, wherein the part of the constant current is 11.3mA. The current consumed by the I²L circuits amounts to about 20mA. For comparison, the total current consumption in a known integrated circuit will amount to 42mA. In contrast, when the I²L circuits are inserted at locations of the analogue circuits where constant currents flow according to the teaching of the invention, the corresponding total current consumption can be reduced to 30.7mA. This value can be further reduced by adapting such configuration as shown in Fig. 23.

In this manner, it is not necessary to provide current supply circuits for I²L circuits. The currents which flow in the other circuits also flow through the I²L circuits, so that the power consumption of the whole integrated circuit can be significantly reduced.

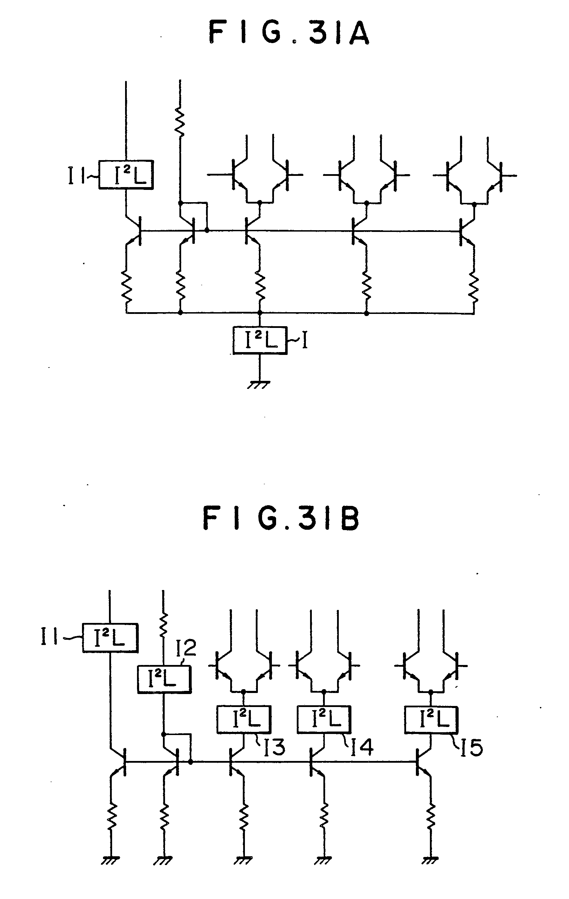

Figs. 31A and 31B show embodiments of the invention in which I²L circuitries (I, I1, . . . , 15) are inserted in differential amplifier circuits at constant current locations. Such a differential circuit is employed very frequently in various integrated circuits. A great number of the differential circuits are often incorportated in a single chip. Thus, insertion of I²L circuits in these differential circuits for making double use of the substantially constant current is very significant in reducing the power consumption of the whole integrated circuit.

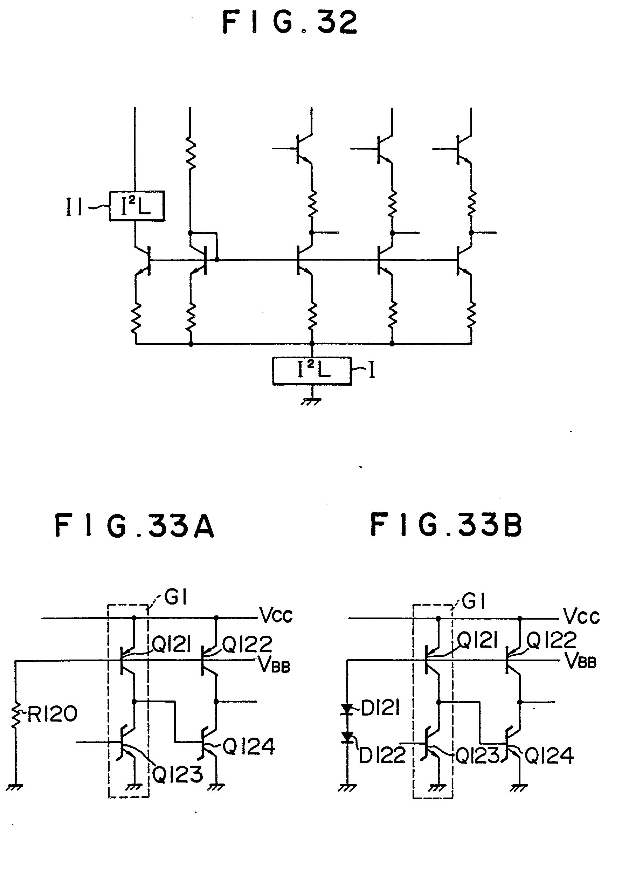

Fig. 32 shows another embodiment of the invention in which I²L circuits are provided in a level shifting circuit. Since this type of circuit is used in various integrated circuits as often as the differential amplifier circuit, the use of I²L circuits in the level shifting circuits is also of much significance for reducing the power consumption of the integrated circuit as a whole.

In the foregoing description, it has been assumed that the I²L circuits are provided in analogue circuits. However, it is equally possible to incorporate the I²L circuits in other circuits such as logical operation circuits. For example, the differential amplifier circuits as described above can be employed in logical operation circuits termed CML and ECL. In the following, examples of the logical operation circuit to which the invention can be applied will be described.

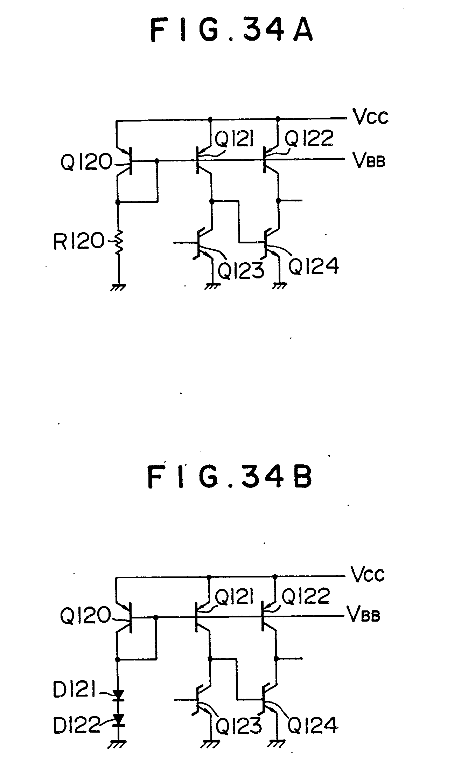

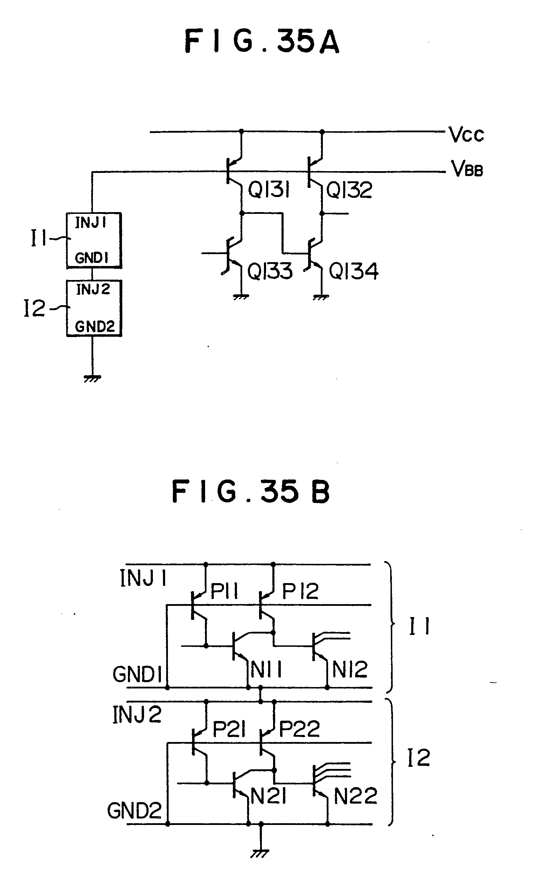

Figs. 33A, 33B, 34A and 34B show logical operation circuits constituted by transistors Q123 and Q124 each provided with a clamping Schottky diode which are disclosed in Japanese Laid-Open Utility Model Specification No. 169454/1979. The load of an inverter gate G1 of the logical operation circuit is a pnp-transistor of constant current performance. The base electrodes of the pnp-transistors are biased through a resistor R120 as shown in Fig. 33A or by means of diodes D121 and D122 as shown in Fig. 34B or alternatively by means of a constant current source circuit as shown in Figs. 34A and 34B. The Schottky clamp logic operation circuits are capable of operating at a speed about ten or more times as high as the operation of a standard I²L circuit, and require a correspondingly increased current consumption. Thus, it is possible (and advantageous) to provide the I²L circuits in the pnp-transistors of the logical operation circuits shown in Figs. 33A and 33B as described above with reference to Figs. 25B, 26 and 27. Further, it is also possible to provide I²L circuits connected to the base electrodes of the pnp-transistor, as shown in Figs. 35A and 35B, thereby to save current consumption for the I²L circuits I1 and I2. The illustrated embodiment can be advantageously applied to a system in which high speed operation is attained by the circuits shown in Figs. 33A and 33B while the low speed operation is by the I²L circuits. The necessity of providing separate current for the I²L circuitries is obviated.

As will be appreciated from the foregoing description on the various embodiments of the invention, the present invention makes it possible significantly to reduce the power consumption or wastage of the integrated circuit on the whole by causing the current which flows in other coexistent circuits, also to flow through the low voltage circuit such as I²L circuits. The conventional integrated circuits have numerous circuit portions at which the low voltage circuit may be situated. Thus, the invention can be advantageously applied to almost all kinds of the integrated circuits.

The requirement of low power consumption or dissipation in the integrated circuit is essential in miniaturization and portableness of systems and will be of increasing importance. Devices capable of operating with a reduced power supply also provide the users with a great economic advantage. The invention has now provided the low power operation devices and makes great contributions to the relevant fields economically and technologically.

**Claims**

1. A semiconductor integrated circuit comprising a low voltage operation circuit and a high voltage operation circuit operating at a higher voltage than that of said low voltage operation circuit and implemented in coexistence with said low voltage operation circuit in the same integrated circuit;

characterised in that:

said low voltage operation circuit (I) is inserted in a current path of said high voltage operation circuit (Q) through which path a substantially constant current flows so that said high voltage operation circuit serves as a current supply source for said low voltage operation circuit in addition to other functions and operations inherent to said high voltage operation circuit, thereby to allow the current which flows through said high voltage operation circuit also to flow through said low voltage operation circuit.

2. A semiconductor integrated circuit according to claim 1, wherein the high voltage operation circuit includes at least one of a constant current source circuit, a constant voltage source circuit, a differential amplifier, a level shifting circuit, and a logical operation circuit.

3. A semiconductor integrated circuit according to claim 1 or claim 2, wherein said current path includes the path between a power supply line and the high voltage operation circuit.

4. A semiconductor integrated circuit according to claim 3, wherein the high voltage operation circuit comprises a constant current circuit having a pair of transistors (Q21, Q22) collector paths have constant current flows, the base electrodes of the transistors being connected together, the emitter electrodes of the transistors being connected to an earth line, and the base and collector electrodes of one of the transistors being connected together, and wherein the low voltage operation circuit is connected to one of the collector paths of said transistors.

5. A semiconductor integrated circuit according to claim 4, wherein a first low voltage operation circuit is connected to the collector path of said one transistor (Q21), and a second low voltage operation circuit is connected to the collector path of the other transistor (Q22).

6. A semiconductor integrated circuit according to claim 3, wherein the high voltage operation circuit comprises a constant voltage circuit having a transistor (Q31) whose collector path has a substantially constant current flow, the emitter electrode of the transistor being connected to a ground line and the base electrode being connected to a source of constant potential, and wherein the low voltage operation circuit (I3) is connected to the collector path of the transistor.

7. A semiconductor integrated circuit according to claim 3, wherein the high voltage operation circuit comprises a differential amplifier having a pair of transistors (Q41, Q42), the emitter electrodes of the transistors being connected together, and the base electrodes of the transistors being connected so as to receive input signals to be amplified by the differential amplifier, and wherein the low voltage operation circuit (I1) is connected to the collector electrodes of the transistors.

8. A semiconductor integrated circuit according to claim 3, wherein the high voltage operation circuit comprises a constant current MOS circuit having a pair of MOS transistors (Q61, Q62) which have a constant current flow along their drain-source paths, one end of the drain-source paths being connected to a ground line, the gate electrodes of the transistors being connected together, and the other end of the said drain-source path of one transistor being connected to its gate electrode, and wherein the low voltage operation circuit (I1, I2, I3) is connected between the other ends of the drain-source paths of the transistors and the power line.

9. A semiconductor integrated circuit according to claim 1 or claim 2, wherein said current path includes a path between the high voltage operation circuit and a ground line.

10. A semiconductor integrated circuit according to claim 9, wherein the high voltage operation circuit comprises a constant current circuit having a pair of transistors (Q21, Q22) whose emitter paths have constant current flows, the collector electrodes of the transistors being connected to a power line, and the collector and base of one transistor being connected together, and wherein the low voltage operation circuit (I) is connected to the emitter paths of the transistors.

11. A semiconductor integrated circuit according to claim 10, wherein a first low voltage operation circuit (I1) is connected to the emitter path of said one transistor and a second low voltage operation circuit (I2) is connected to the emitter path of the other transistor.

12. A semiconductor integrated circuit according to claim 9, wherein the high voltage operation circuit comprises a constant current circuit having a transistor (Q31) whose emitter path has a constant current flow, the collector electrode of the transistor being connected to a power line and the base electrode being connected to a source of constant potential, and wherein the low voltage operation circuit (I1, I2) is connected to the emitter path of the transistor.

13. A semiconductor integrated circuit according to claim 9, wherein the high voltage operation circuit comprises a differential amplifier having a pair of transistors (Q41, Q42), the collector electrodes of the transistors being connected together, and the base electrodes being connected so as to receive input signals to be amplified by the differential amplifier, and wherein the low voltage operation circuit (I2) is connected to the emitter electrodes of the transistors.

14. A semiconductor integrated circuit according to claim 9, wherein the high voltage operation circuit comprises a constant current MOS circuit having a pair of MOS transistors (Q61, Q62) which have constant current flows along their drain-source paths, one end of the drain-source paths being connected to a power line, the gate electrodes of the transistor being connected together, and said one end of the drain-source path of one transistor being connected to its gate electrode, and wherein the low voltage operation circuit (I4) is connected between the other ends of the drain-source paths of the transistors and the ground line.

15. A semiconductor integrated circuit according to claim 9, wherein the high voltage operation circuit comprises a constant voltage source which includes a transistor (Q31) and a resistor connected to the base electrode of the transistor, the collector electrode being connected to a power line, and the emitter electrode being connected to the ground line, and wherein the low voltage operation circuit (I1, I2) is connected so as to receive a substantially constant current in the base circuit.

16. A semiconductor integrated circuit according to claim 9, wherein the high voltage operation circuit comprises a current compensation circuit having two transistors (Q81, Q82) whose combined emitter currents are substantially constant, the collector electrodes of the transistors being connected to a power line, the base electrode of one of the transistors being connected to the collector electrode of the other transistor, the base of said other transistor being connected so as to receive an input signal to the high voltage operation circuit, and the emitter electrode of said other transistor forming an output terminal for the high voltage operation circuit, and wherein the low voltage operation circuit (I) is connected so as to receive the combined emitter currents of the transistors.

17. A semiconductor integrated circuit according to any one of claims 1 to 3 or 9, wherein the high voltage operation circuit is a MOS circuit which includes a MOS transitor and a constant current gate bias circuit for the MOS transistor, the drain-source path of the MOS transistor being connected between a power supply line and a ground line, and wherein the low voltage operation circuit is connected to the constant current bias circuit.

18. A semiconductor integrated circuit according to any one of claims 1 to 3 or 9, wherein the high voltage operation circuit comprises a constant current circuit including a first pnp-transistor (Q91) having an emitter electrode connected to a power line, a collector electrode connected to the low voltage operation circuit (I₁), and a base electrode connected to its collector electrode, and second and third pnp-transistors (Q92, Q93) each having a base electrode connected to the base electrode of the first transistor and an emitter electrode connected to the power line, the collector electrodes of the first, second and third transistors being connected together.

19. A semiconductor integrated circuit according to any one of claims 1 to 3 or 9, wherein the high voltage operation circuit comprises a logic circuit having two Schottky clamped transistors (Q133, Q134) and two pnp load transistors (Q131, Q132) whose collector electrodes are respectively connected to a corresponding collector electrode of the Schottky transistors, the emitter electrodes of the load transistors being connected to a power line (Vcc), the emitter electrodes of the Schottky transistors being connected to a ground line, a base electrode of the Schottky transistors being connected so to receive an input signal for the high voltage operation circuit, the collector electrode of said one Schottky transistor being connected to the base electrode of the other Schottky transistor, and the collector electrode of said other Schottky transistor being an output terminal for the high voltage operation circuit, and wherein the low voltage operation circuit (I1, I2) is connected to the base electrodes of the load transistors.

20. A semiconductor integrated circuit according to any one of the preceding claims, wherein the high voltage operation circuit includes a control terminal, and the low voltage operation circuit is connected to the control terminal so as to provide a constant current bias to the control terminal.

21. A semiconductor integrated circuit according to claim 20, wherein the high voltage operation circuit includes at least one bipolar transistor (Q21) whose base and collector electrodes are connected to the low voltage operation circuit (I5), and base electrode being the control terminal, so that the low voltage operation circuit provides constant current bias to the base electrode of the bipolar transistor and so provides a constant current at the collector electrode of the bipolar transistor.

22. A semiconductor integrated circuit according to any one of the preceding claims, wherein said low voltage operation circuit comprises an I²L circuit.

23. A semiconductor integrated circuit according to claim 22, wherein said I²L circuit includes a plurality of divided blocks which are connected in a stacked configuration.

**Patentansprüche**

1. Integrierte Halbleiterschaltung mit einer Niederspannungsbetriebsschaltung und einer Hochspannungsbetriebsschaltung, die bei einer höheren Spannung arbeitet als die Niederspannungsbetriebsschaltung und die zusammen mit der Niederspannungsbetriebsschaltung in der gleichen integrierten Schaltung aufgebaut ist, dadurch gekennzeichnet, daß die Niederspannungsbetriebsschaltung (I) in den Stromweg der Hockspannungsbetriebsschaltung (Q) eingesetzt ist, durch den ein im wesentlichen konstanter Strom so fließt, daß die Hochspannungsbetriebsschaltung zusätzlich zu den ihr innewohnenden anderen Funktionen und Operationen als Stromversorgungsquelle für die Niederspannungsbetriebsschaltung arbeitet, so daß der Strom, der durch die Hochspannungsbetriebsschaltung fließt, ebenfalls durch die Niederspannungsbetriebsschaltung fließen kann.

2. Integrierte Halbleiterschaltung nach Anspruch 1, bei der die Hochspannungsbetriebsschaltung wenigstens eine Schaltung aus der eine Konstantstromquellenschaltung, eine Konstantspannungsquellenschaltung, einen Differenzverstärker, eine Pegelschiebeschaltung und eine Schaltung für logische Operationen umfassenden Schaltungsgruppe aufweist.

3. Integrierte Halbleiterschaltung nach Anspruch 1 oder 2, bei der der Stromweg den Weg zwischen einer Spannungsversorgungsleitung und der Hochspannungsbetriebsschaltung einschließt.

4. Integrierte Halbleiterschaltung nach Anspruch 3, bei der die Hochspannungsbetriebsschaltung eine Konstantstromschaltung mit einem Paar von Transistoren (Q21, Q22) umfaßt, deren Kollektorwege konstanten Stromfluß zeigen, wobei die Basiselektroden der Transistoren miteinander verbunden sind, die Emitterelektroden der Transistoren mit einer Erdleitung verbunden sind, und die Basis- und Kollektorelektroden von einem der Transistoren miteinander verbunden sind, und wobei die Niederspannungsbetriebsschaltung mit einem der Kollektorwege der Transistoren verbunden ist.

5. Integrierte Halbleiterschaltung nach Anspruch 4, bei der eine erste Niederspannungsbetriebsschaltung mit dem Kollektorweg von dem einen Transistor (Q21) und eine zweite Niedersapannungsbetriebsschaltung mit dem Kollektorweg des anderen Transistors (Q22) verbunden sind.

6. Integrierte Halbleiterschaltung nach Anspruch 3, bei der die Hochspannungsbetriebsschaltung eine Konstantspannungsschaltung mit einem Transistor (Q31) aufweist, dessen Kollektorweg im wesentlichen konstanten Stromfluß hat und dessen Emitterelektrode mit einer Masseleitung und dessen Basiselektrode mit einer Quelle für konstantes Potential verbunden sind, und bei der die Niederspannungsbetriebsschaltung (I3) mit dem Kollektorweg des Transistors verbunden ist.

7. Integrierte Halbleiterschaltung nach Anspruch 3, bei der die Hockspannungsbetriebsschaltung einen Differenzverstärker mit einem Paar von Transistoren (Q41, Q42) aufweist, wobei die Emitterelektroden der Transistoren miteinander verbunden sind und die Basiselektroden der Transistoren so geschaltet sind, daß sie die durch den Differenzverstärker zu verstärkenden Eingangssignale empfangen, und wobei die Niederspannungsbetriebsschaltung (I1) mit den Kollektorelektroden der Transistoren verbunden ist.

8. Integrierte Halbleiterschaltung nach Anspruch 3, bei der die Hochspannungsbetriebsschaltung eine Konstantstrom - MOS - Schaltung mit einem Paar von MOS-Transistoren (Q61, Q62) aufweist, die entlang ihrer Drain-Source-Wege einen Konstanten Stromfluß haben, und wobei ein Ende der Drain-Source-Wege mit einer Masseleitung, die Gateelektroden der Transistoren miteinander und das andere Ende des Drain-Source-Weges eines Transistors mit seiner Gateelektrode verbunden sind, und wobei die Niederspannungsbetriebsschaltung (I1, I2, I3) zwischen die anderen Enden der Drain-Source-Wege der Transistoren und die Spannungsversorgungsleitung geschaltet sind.

9. Integrierte Halbleiterschaltung nach Anspruch 1 oder 2, bei der der Stromweg einen Pfad zwischen der Hochspannungsbetriebsschaltung und einer Masseleitung umfaßt.

10. Integrierte Halbleiterschaltung nach Anspruch 9, bei der die Hochspannungsbetriebsschaltung eine Konstantstromschaltung mit einem Paar von Transistoren (Q21, Q22) umfaßt, deren Emitterwege konstanten Stromfluß haben, und wobei die Kollektorelektroden der Transistoren mit einer Versorgungsleitung verbunden sind und der Kollektor und die Basis von einem Transistor miteinander verbunden sind, und wobei die Niederspannungsbetriebsschaltung (I) mit den Emitterwegen der Transistoren verbunden ist.

11. Integrierte Halbleiterschaltung nach Anspruch 10, bei der eine erste Niederspannungsbetriebsschaltung (I) mit dem Emitterweg von dem einen Transistor und eine zweite Niederspannungsbetriebsschaltung (I2) mit dem Emitterweg des anderen Transistors verbunden sind.

12. Integrierte Halbleiterschaltung nach Anspruch 9, bei der die Hochspannungsbetriebsschaltung eine Konstantstromschaltung mit einem Transistor (Q31) umfaßt, dessen Emitterweg einen konstanten Stromfluß hat, und wobei die Kollektorelektrode des Transistors mit einer Versorgungsleitung und die Basiselektrode mit einer Quelle konstanten Potentials verbunden sind, und wobei die Niederspannungsbetriebsschaltung (I1, I2) mit dem Emitterweg des Transistors verbunden ist.

13. Integrierte Halbleiterschaltung nach Anspruch 9, bei der die Hochspannungsbetriebsschaltung einen Differenzverstärker mit einem Paar von Transistoren (Q41, Q42) umfaßt, wobei die Kollektorelektroden der Transistoren miteinander verbunden sind und die Basiselektroden so angeschlossen sind, daß sie die durch den Differenzverstärker zu verstärkenden Eingangssignale empfangen, und wobei die Niederspannungsbetriebsschaltung (I2) mit den Emitterelektroden der Transistoren verbunden ist.

14. Integrierte Halbleiterschaltung nach Anspruch 9, bei der die Hochspannungsbetriebsschaltung eine Konstantstrom-MOS-Schaltung mit einem Paar von MOS-Transistoren (Q61, Q62) aufweist, die entlang ihrer Drain-Source-Wege konstanten Stromfluß haben, wobei ein Ende der Drain-Source-Wege mit einer Versorgunsleitung verbunden ist, die Gateelektroden des Transistors miteinander verbunden sind und das eine Ende des Drain-Source-Weges von einem Transistor mit seiner Gateelektrode verbunden ist, und wobei die Niederspannungsbetriebsschaltung (I4) zwischen die anderen Enden der Drain-Source-Wege der Transistoren und die Msseleitung geschaltet ist.

15. Integrierte Halbleiterschaltung nach Anspruch 9, bei der die Hochspannungsbetriebsschaltung eine Konstantspannungsquelle umfaßt, die einen Transistor (Q31) und einen Widerstand enthält, der mit der Basiselektrode des Transistors verbunden ist, wobei die Kollektorelektrode mit einer Versorgunsleitung und die Emitterelektrode mit der Masseleitung verbunden sind, und wobei die Niederspannungsbetriebsschaltung (I1, I2) so geschaltet ist, daß sie in der Bassisschaltung einen im wesentlichen konstanten Strom empfängt.

16. Integrierte Halbleiterschaltung nach Anspruch 9, bei der die Hochspannungsbetriebsschaltung eine Stromkompensationsschaltung mit zwei Transistoren (Q81, Q82) aufweist, deren vereinigte Emitterströme im wesentlichen konstant sind, wobei die Kollektorelektrode der Transistoren mit einer Versorgungsleitung verbunden ist und die Basiselektrode von einem der Transistoren mit der Kollektorelektrode des anderen Transistors verbunden ist, wobei die Basis des anderen Transistors so geschaltet ist, daß sie einen Eingangsanschluß für die Hochspannungsbetriebsschaltung bildet, und wobei die Niederspannungsbetriebsschaltung (I) so geschaltet ist, daß sie die vereinigten Emitterströme der Transistoren empfängt.

17. Integrierte Halbleiterschaltung nach einem der Ansprüche 1 bis 3 oder nach Anspruch 9, bei der die Hochspannungsbetriebsschaltung eine MOS-Schaltung ist, die einen MOS-Transistor und eine Konstantstrom-Tor-Vorstrom-Schaltung für den MOS-Transistor enthält, wobei der Drain-Source-Weg des MOS-Transistors zwischen eine Spannungsversorgungsleitung und eine Masseleitung geschaltet ist, und wobei die Niederspannungsbetriebsschaltung mit der Konstantstrom-Vorstromschaltung verbunden ist.

18. Integrierte Halbleiterschaltung nach einem der Ansprüche 1 bis 3 oder nach Anspruch 9, bei der die Hochspannungsbetriebsschaltung eine Konstantstromschaltung umfaßt, die einen ersten pnp-Transistor (Q91) aufweist, bei dem eine Emitterelectrode mit einer Spannungsversorgungsleitung verbunden ist, eine Kollektorelektrode mit der Niederspannungsbetriebsschaltung (I1) und eine Basiselektrode mit ihrer Kollektorelektrode verbunden sind, und wobei die Hochspannungsbetriebsschaltung einen zweiten und einen dritten pnp-Transistor (Q92, Q93) umfaßt, bei denen jeweils eine Basiselektrode mit der Basiselektrode des ersten Transistors und eine Emitterelektrode mit der Spannungsversorgungsleitung verbunden sind, und wobei die Kollektorelektroden des ersten, des zweiten und des dritten Transistors miteinander verbunden sind.

19. Integrierte Halbleiterschaltung nach einem der Ansprüche 1 bis 3 oder nach Anspruch 9, bei der die Hochspannungsbetriebsschaltung eine logische Schaltung mit zwei Schottky - klemmgeschalteten Transistoren (Q133, Q134) und zwei pnp-Last-Transistoren (Q131, Q132) aufweist, deren Kollektorelektroden jeweils mit einer entsprechenden Kollektorelektrode der Schottky - Transistoren verbunden sind, bei der die Emitterelektroden der Lasttransitoren mit einer Spannungsversorgungsleitung (Vcc), die Emitterelektroden der Schottky - Transistoren mit einer Masseleitung verbunden sind und bei der die Basiselektrode von einem der Schottky - Transistoren so geschaltet ist, daß diese ein Eingangssignal für die Hochspannungsversorgungsschaltung empfängt, ferner die Kollektorelektrode von einem der Schottky - Transistoren mit der Basiselektrode des anderen Schottky-Transistors, die Kollektorelektrode des anderen Schottky - Transistors mit einem Ausgansanschluß für die Hochspannungsbetriebsschaltung und die Niederspannungsbetriebsschaltung (I1, I2) mit den Basiselektroden der Last - Transistoren verbunden ist.

20. Integrierte Halbleiterschaltung nach einem der vorangehenden Ansprüche, bei der die Hochspannungsbetriebsschaltung einen Steueranschluß aufweist und die Niederspannungsbetriebsschaltung mit dem Steueranschluß verbunden ist, so daß ein konstanter Vorstrom dem Steueranschluß zugeführt wird.

21. Integrierte Halbleiterschaltung nach Anspruch 20, bei der die Hochspannungsbetriebsschaltung weinigstens einen bipolaren Transistor (Q21) aufweist, deren Basisund Emitterelektroden mit der Niederspannungsbetriebsschaltung (15) verbunden sind, und wobei die Basiselektrode der Steueranschaluß ist, so daß Niederspannungsbetriebsschaltung einen konstanten Vorstrom der Basiselektrode des bipolaren Transistors zuführt und somit einen konstanten Strom an der Kollektorelektrode des bipolaren Transistors liefert.

22. Integrierte Halbleiterschaltung nach einem der vorangehenden Ansprüche, bei der die Niederspannungsbetriebsschaltung eine $I^2L$-Schaltung aufweist.

23. Integrierte Halbleiterschaltung nach Anspruch 22, bei der die $I^2L$-Schaltung eine Anzahl von aufgeteilten Blöcken enthält, die in Stapel - Konfiguration miteinander verschaltet sind.

**Revendications**

1. Circuit intégré à semiconducteurs comprenant un circuit fonctionnant avec une basse tension et un circuit fonctionnant avec une tension élevée, qui est supérieure à celle dudit ciruit fonctionnant avec une basse tension, et présent conjointement avec ledit circuit fonctionnant avec une basse tension dans le même circuit intégré, caractérisé en ce que ledit circuit fonctionnant avec une basse tension (I) est inséré dans une voie de courant dudit circuit fonctionnant avec une tension élevée (Q), à travers laquelle un courant essentiellement constant circule de telle sorte que ledit circuit fonctionnant avec une tension élevée sert de source d'alimentation en courant pour ledit circuit fonctionnant avec une basse tension, en dehors du fait d'exécuter d'autres fonctions et opérations propres audit circuit fonctionnant avec une tension élevée, ce qui permet au courant qui circule dans ledit circuit fonctionnant avec une tension élevée, de circuler également dans ledit circuit fonctionnant avec une basse tension.

2. Circuit intégré à semiconducteurs selon la revendication 1, dans lequel le circuit fonctionnant avec une tension élevée comporte au moins un circuit formant source de courant constant, un circuit formant source de tension constante, un amplificateur différentiel, un circuit de décalage de niveau et un circuit à fonctionnement logique.

3. Circuit intégré à semiconducteurs selon la revendication 1 ou 2, dans lequel ladite voie de courant inclut la voie s'étendant entre une ligne d'alimentation en énergie et le circuit fonctionnant avec une tension élevée.

4. Circuit intégré à semiconducteurs selon la revendication 3, dans lequel le circuit fonctionnant avec une tension élevée comporte un circuit à courant constant comprenant un couple de transistors (Q21, Q22) dans les voies des collecteurs desquels circulent des courants constants, les électrodes de base des transistors étant raccordées ensemble, les électrodes d'émetteur des transistors étant raccordées à une ligne de masse et les électrodes de base et de collecteur d'un premier des transistors étant raccordées ensemble, et dans lequel le circuit fonctionnant avec une basse tension est raccordé à l'une des voies des collecteurs desdits transistors.

5. Circuit intégré à semiconducteurs selon la revendication 4, dans lequel un premier circuit fonctionnant avec une basse tension est raccordé à la voie de collecteur dudit premier transistor (Q21), et un second circuit fonctionnant avec une basse tension est raccordé à la voie de collecteur du second transistor (Q22).

6. Circuit intégré à semiconducteurs selon la revendication 3, dans lequel le circuit fonctionnant avec une tension élevée comporte un circuit à tension constante, comprenant un transistor (Q31) dans la voie de collecteur duquel circule un courant essentiellement constant, l'électrode d'émetteur du transistor étant raccordée à une ligne de masse et l'électrode de base étant raccordée à une souce de potentiel constant, et dans lequel le circuit fonctionnant avec une basse tension (I3) est raccordé à la voie de collecteur du transistor.

7. Circuit intégré à semiconducteurs selon la revendication 3, dans lequel le circuit fonctionnant avec une tension élevée comprend un amplificateur différentiel possédant un couple de transistors (Q41, Q42), les électrodes d'émetteur des transistors étant raccordées ensemble, et les électrodes de base des transistors étant raccordées de manière à recevoir des signaux d'entrée devant être amplifiés par l'amplificateur différentiel, et dans lequel le circuit fonctionnant avec une basse tension (I1) est raccordé aux électrodes de collecteur des transistors.

8. Circuit intégré à semiconducteurs selon la revendication 3, dans lequel le circuit fonctionnant avec une tension élevée comporte un circuit MOS à courant constant comprenant un couple de transistors MOS (Q61, Q62), dans le voies drain-source desquelles circulent des courants constants, une extrémité des voies drain-source étant raccordée à une ligne de masse, les électrodes de grille des transistors étant raccordées ensemble, et l'autre extrémité de ladite voie drain-source d'un transistor étant raccordée à son électrode de grille, et dans lequel le circuit fonctionnant avec une basse tension (I1, I2, I3) est raccordé entre les autres extrémités des voies drain-source des transistors et la ligne d'alimentation en énergie.

9. Circuit intégré à semiconducteurs selon la revendication 1 ou 2, dans lequel ladite voie de courant inclut une voie située entre le circuit fonctionnant avec une tension élevée et une ligne de masse.

10. Circuit intégré selon la revendication 9, dans lequel ledit circuit fonctionnant avec une tension élevée comporte un circuit à courant constant possédant deux transistors (Q21, Q22), dans les voies d'émetteur desquels circulent des courants constants, les électrodes de collecteur des transistors étant raccordées à une ligne d'alimentation en énergie, et le collecteur et la base d'un transistor étant raccordés ensemble, et dans lequel le circuit fonctionnant avec une base tension (I) est raccordé aux voies d'émetteur des transistors.

11. Circuit intégré à semiconducteurs selon la revendication 10, dans lequel un premier circuit fonctionnant avec une basse tension (I1) est raccordé à la voie d'émetteur dudit premier transistor et un second circuit fonctionnant avec une basse tension (I1) est raccordé à la voie d'émetteur de l'autre transistor.

12. Circuit intégré à semiconducteurs selon la revendication 9, dans lequel le circuit fonctionnant avec une tension élevée comprend un circuit à courant constant comportant un transistor (Q31), dans la voie d'émetteur duquel circule un courant constant, l'électrode de collecteur du transistor étant raccordée à une ligne d'alimentation en énergie et l'électrode de base étant raccordée à une source de potentiel constant, et dans lequel le circuit fonctionnant avec une basse tension (I1, I2) est raccordé à la voie d'émetteur du transistor.

13. Circuit intégré à semiconducteurs selon la revendication 9, dans lequel le circuit fonctionnant avec une tension élevée comprend un amplificateur différentiel comportant deux transistor (Q41, Q42), les électrodes de collecteur des transistors étant raccordées ensemble, et les électrodes de base étant raccordées de manière à recevoir des signaux d'entrée destinés à être amplifiés par l'amplificateur différential, et dans lequel le circuit fonctionnant avec une basse tension (I2) est raccordé aux électrodes d'émetteur des transistors.

14. Circuit intégré à semiconducteurs selon la revendication 9, dans lequel le circuit fonctionnant avec une tension élevée comprend un circuit MOS à courant constant comprenant un couple de transistor MOS (Q61, Q62), dans les voies drain-source desquels circulent des courants constants, une première extrémité des voies drain-source étant raccordées à une ligne d'alimentation en énergie, les électrodes de grille des transistors étant raccordées ensemble, et ladite première extrémité de la voie drain-source d'un transistor étant raccordée à son électrode de grille, et dans lequel le circuit fonctionnant avec une basse tension (I4) est branché entre les autres extrémités des voies drain-sources des transistors et la ligne de masse.

15. Circuit intégré à semiconducteurs selon la revendication 9, dans lequel le circuit fonctionnant avec une tension élevée comprend une source de tension constante, qui contient un transistor (Q31) et une résistance raccordée à l'électrode de base du transistor, l'électrode de collecteur étant raccordée à une ligne d'alimentation en énergie et l'électrode d'émetteur étant raccordée à la ligne de masse, et dans lequel le circuit fonctionnant avec une basse tension (I1, I2) est raccordé de manière à recevoir un courant essentiellement constant dans le circuit de base.

16. Circuit intégré à semiconducteurs selon la revendication 9, dans lequel le circuit fonctionnant avec une tension élevée comprend un circuit de compensation de courant possédant deux transistors (Q81, Q82), dont les courants d'émetteur combinés sont essentiellement constants, les électrodes de collecteur des transistors étant raccordées à une ligne d'alimentation en énergie, l'électrode de base d'un premier des transistors étant raccordée à l'électrode de collecteur du second transistor, la base dudit second transistor étant raccordée de manière à recevoir un signal d'entrée envoyé circuit fonctionnant avec une tension élevée, et l'électrode d'émetteur dudit second transistor constituant une borne de sortie pour le circuit fonctionnant avec une tension élevée, et dans lequel le circuit (I) fonctionnant avec une basse tension est branché de manière à recevoir des courants d'émetteur combinés des transistors.

17. Circuit intégré à semiconducteurs selon l'une quelconque des revendications 1 à 3 ou 9, dans lequel le circuit fonctionnant avec une tension élevée est un circuit MOS, qui contient un transistor MOS et un circuit de polarisation de grille à courant constant pour le transistor MOS, la voie drain- source du transistor MOS étant branchée entre une ligne d'alimentation en énergie et une ligne de masse, et dans lequel le circuit fonctionnant avec une basse tension est raccordé au circuit de polarisation à courant constant.

18. Circuit intégré à semiconducteurs selon l'une quelconque des revendications 1 à 3 ou 9, dans lequel le circuit fonctionnant avec une tension élevée comporte un circuit à courant constant comprenant un premier transistor pnp (Q91) possédant une électrode d'émetteur raccordée à une ligne d'alimentation en énergie, une électrode de collecteur raccordée au circuit fonctionnant avec une basse tension (I1) et une électrode de base raccordée à son électrode de collecteur, et des second et triosième transistors pnp (Q92, Q93) comportant chacun une électrode de base raccordée à l'électrode de base du premier transistor et une électrode d'émetteur raccordée à la ligne d'alimentation en énergie, les électrodes de collecteur des premier, second et troisième transistors étant raccordées ensemble.

19. Circuit intégré à semiconducteurs selon l'une quelconque des revendication 1 à 3 ou 9, dans lequel le circuit fonctionnant avec une tension élevée comporte un circuit logique comprenant deux transistors à verrouillage Schottky (Q133, Q134) et deux transistors de charge pnp (Q131, Q132), dont les électrodes de collecteur sont raccordées respectivement à une électrode de collecteur correspondante des transistors Schottky, les électrodes d'émetteur des transistors de charge étant raccordées à une ligne d'alimentation en énergie (Vcc), les électrodes d'émetteur des transistors Schottky étant raccordées à une ligne de masse, une électrode de base d'un premier des transistors Schottky étant raccordée de manière à revevoir un signal d'entrée pour le circuit fonctionnant à haute tension, l'électrode de collecteur dudit premier transistor Schottky étant raccordée à l'électrode de base du second transistor Schottky, et l'électrode de collecteur dudit second transistor Schottky formant une borne de sortie pour le circuit fonctionnant avec une tension élevée, et dans lequel le circuit fonctionnant avec une basse tension (I1, I2), est raccordé aux électrodes de base des transistors de charge.

20. Circuit intégré à semiconducteurs, selon l'une quelconque des revendications précédentes, dans lequel le circuit fonctionnant avec une tension élevée comprend une borne de commande, et le circuit fonctionnant avec une basse tension est raccordé à la borne de commande de manière à fournir une polarisation à courant constant à la borne de commande.

21. Circuit intégré à semiconducteurs selon la revendication 20, dans lequel le circuit fonctionnant avec une tension élevée comprend au moins un transistor bipolaire (Q21), dont les électrodes de base et de collecteur sont raccordées au circuit fonctionnant à basse tension (I5), et l'électrode de base constituant la borne de commande, de telle sorte que le circuit fonctionnant avec une basse tension délivre une polarisation à courant constant à l'électrode de base du transistor bipolaire et envoie ainsi un courant constant à l'électrode de collecteur dudit transistor bipolaire.

22. Circuit intégré à semiconducteurs, selon l'une quelconque des revendications précédentes, dand lequel ledit circuit fonctionnant avec une basse tension inclut un circuit I²L.

23. Circuit intégré à semiconducteurs selon la revendication 22, dans lequel ledit circuit I²L comprend une pluralité de blocs séparés qui sont raccordés selon une configuration empilée.

# F I G. 1A
# PRIOR ART

# F I G. 1B
# PRIOR ART

# F I G. 2A

# F I G. 2B

# F I G. 3B

# F I G. 3A

# F I G . 4

# F I G . 5

# F I G . 6

# F I G . 7

FIG.8A

FIG.8B

FIG.8C

FIG.9

# FIG.IOA

# FIG.IOB

# FIG.IIA

# FIG.IIB

# FIG.12A

# FIG.12B

# FIG.13A

# FIG.13B

FIG.14

F I G . 15

0 063 028

FIG.16

F I G. 17

# F I G .18A

# F I G .18B

# F I G . 18C

0 063 028

# F I G . 19A

# F I G . 19B

# F I G . 20A

# F I G . 20B

## F I G . 21

## F I G . 22

## F I G . 23

# FIG.24A

# FIG.24B

# FIG.25A

# FIG.25B

15

# FIG.26

# FIG.27

0 063 028

# F I G.28A

# F I G.28B

17

0 063 028

# FIG.29A PRIOR ART

# FIG.29B
PRIOR ART

# FIG.29C
PRIOR ART

# FIG.30A

# FIG.30B

18

# F I G . 3 1 A

# F I G . 3 1 B

# F I G . 32

# F I G . 33A

# F I G . 33B

# F I G . 34 A

# F I G . 34 B

# F I G . 35A

# F I G . 35 B